# EUROPEAN PATENT APPLICATION

(11) **EP 1 227 502 A1**
(43) Date of publication of application: **31.07.2002**
(21) Application number: 01400197.8
(22) Date of filing: 25.01.2001
(51) Int. Cl.: G11C 29/00, H01L 21/66

(54) **Connection pad arrangements for electronic circuit comprising both functional logic and flash-EEPROM**

(71) Applicant: ALCATEL, 75008 Paris (FR)
(72) Inventor: Schmit, Jean-Jacques, 1342 Ottignies (BE); Op 'T Eynde, Frank Nico Lieven, B-3012 Wilsele (Leuven) (BE); Charlier, Vincent Jean-Marie Octave, 1160 Auderghem (BE)
(74) Representative: Narmon, Gisèle Marie Thérèse

(57) **Abstract**

An integrated circuit (IC1) comprising functional logic (1) and Flash-EEPROM (2) coupled, via mixing devices (IMUX, OMUX), to connection pads (CP1, CP2), which are arranged into pad arrangements (PAD: PAD1, PAD2, PAD3, PAD4). Each pad arrangement (PAD) comprises two juxtaposed connection pads (CP1, CP2) interconnected electrically and having substantially the same design. In this way, many "probings" are possible on a same pad arrangement, while probing at most two times each connection pad thereof.. By probing at most two times on a connection pad, a good "bondability" of the pad is assured. This is particularly useful in the present case of combined functional logic and the Flash-EEPROM where three probings are generally required for the flash test of the EEPROM, the digital test of the functional logical and the analog test of the latter. In a preferred embodiment, the integrated circuit (IC2) comprises a first set of dedicated connection pads (PAD10, PAD11, PAD12) coupled to the functional logic (1), and a distinct second set of dedicated connection pads (PAD21, PAD22) coupled to the Flash-EEPROM (2).

## Description

The present invention relates to an integrated circuit comprising functional logic and Flash-EEPROM coupled to at least one connection pad of said integrated circuit.

It is only recently that both functional, or "classical", logic and Flash-EEPROM are integrated on a same integrated circuit. The production of such electronic circuits obviously requires testing them, already at wafer level. To this end, connection pads are provided to make the components of the circuit accessible for test and connection purposes to the external world.

In case of a known integrated circuit comprising only functional logic, test signals and functional signals are generally mixed on same pads in order to minimize the number of connections and pins on the package. A connection pad is a rectangle used for "probing" during the test phase of the integrated circuit. It may then be reused for "bonding" to an external pin of the chip carrying the integrated circuit.

When a chip contains both a Flash-EEPROM and a functional logic, a connection pad may need to be probed three or four times: generally two times in foundry for a flash test, a third time on a digital tester and a fourth time on an analog tester. The problem is that a connection pad should preferably only be probed twice in order to guarantee a good "bondability". This means that a third probing cycle is no longer possible.

A possible solution to limit the probing to two accesses to the connection pad is to use an analog tester that is also adapted to make digital tests. Although such an analog tester is already known in the art, this test solution is relatively expensive, especially because of the very slow test time of analog testers compared to the test time of dedicated digital testers.

An object of the present invention is to provide an integrated circuit of the type comprising both functional logic and Flash-EEPROM, and whereof the test may be performed in an optimum way regarding cost and speed.

According to the invention, this object is achieved due to the fact that several connection pads are arranged into a pad arrangement, and that said integrated circuit further comprises mixing devices adapted to couple said functional logic and said Flash-EEPROM to a connection pad of said pad arrangement.

In this way, probing may be performed two times on each of the connection pads constituting the pad arrangement. The above mentioned three times probing for the flash test, digital test and analog test is thus possible on a pad arrangement with only two connection pads, and without affecting the bondability of these connection pads.

Another characterizing embodiment of the present invention is that said pad arrangement comprises at least two juxtaposed connection pads interconnected electrically.

By reducing the distance between the two connection pads of the pad arrangement, differences in measurements are avoided. Such differences could for instance be generated by electrical fields or any other high frequency signal.

Also another characterizing embodiment of the present invention is that said two juxtaposed connection pads have substantially the same design.

This facilitates the production process.

In a preferred embodiment of the present invention, said integrated circuit further comprises a first set of dedicated connection pads coupled to said functional logic and a second set of dedicated connection pads coupled to said Flash-EEPROM.

A chip with a Flash-EEPROM is often relatively large compared to the required number of functional pads. The Flash-EEPROM increases the area of the core and reduces the number of external pads. The integration of the Flash-EEPROM suppresses the need of an external Flash-EEPROM (or memory) interface. There is thus generally sufficient space for additional connection pads. Consequently, dedicated pads, with pull-up/pull-down features, may be used to test the Flash at probe level. A main advantage of this preferred solution is that no special connection pad needs to be designed, only standard connection pads are used.

Further characterizing embodiments of the present invention are mentioned in the appended claims.

It is to be noticed that the term 'comprising', used in the claims, should not be interpreted as being restricted to the means listed thereafter. Thus, the scope of the expression 'a device comprising means A and B' should not be limited to devices consisting only of components A and B. It means that with respect to the present invention, the only relevant components of the device are A and B.

The above and other objects and features of the invention will become more apparent and the invention itself will be best understood by referring to the following description of an embodiment taken in conjunction with the accompanying drawings wherein:
Fig. 1 represents an integrated circuit IC1 according to the invention and comprising mixing devices coupling functional logic and Flash-EEPROM to connection pad arrangements;
Fig. 2 is a detail view of a duplicated connection pad PAD of the integrated circuit IC1 of Fig. 1; and
Fig. 3 represents a preferred embodiment of the invention with the functional logic and the Flash-EEPROM of the integrated circuit IC2 connected to dedicated connection pads.

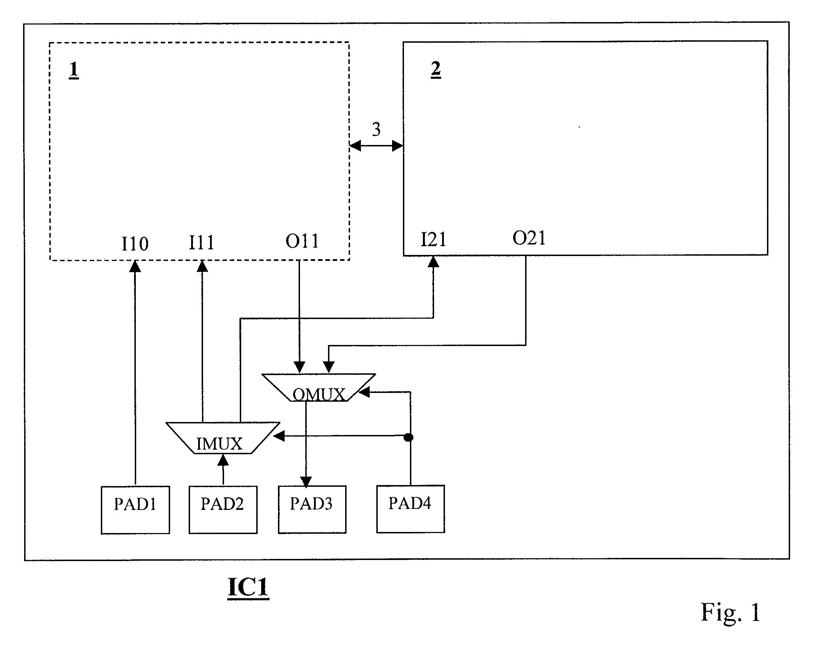

The integrated circuit IC1 shown at Fig. 1 is an electronic chip comprising interconnected functional logic, generally indicated by numeral 1, and Flash-EEPROM, generally indicated by numeral 2, the functional logic 1 being constituted by analog logic and/or digital logic. Parts of the components of the integrated circuit IC1 need to be accessible to the external world for test and for connection purposes, such parts will be called "ports" hereafter. To this end, the ports are connected to pad arrangements, such as PAD1 to PAD4, which are provided on the chip. During the production phase of the chip, connection pad arrangements are only used for test purpose, i.e. "probing". At the end of the production phase, pad arrangements may also be used for connecting wires thereto, i.e. "bonding", in order to couple the integrated circuit IC1 to other items.

In the example of Fig. 1, a first connection pad PAD1 is an input pad connected to a first input port I10 of the functional logic 1. A second connection pad PAD2 is an input pad coupled either to a second input port I11 of the functional logic 1 or to an input port I21 of the Flash-EEPROM 2. The pad PAD2 is coupled to these ports via a first mixing device or multiplexer IMUX having an input connected to PAD2, a first output connected to I11 and a second output connected to I21. A third connection pad PAD3 is an output pad to which is coupled either an output port O11 of the functional logic 1 or an output port 021 of the Flash-EEPROM 2. These output ports are coupled to the pad PAD3 via a second mixing device OMUX having a first input connected to O11, a second input connected to 021 and an output connected to PAD3. Finally, a fourth connection pad PAD4 is connected to a control input of the multiplexers IMUX and OMUX. A signal applied to this pad PAD4 controls IMUX/OMUX to connect its first or its second output/input to its input/output, respectively.

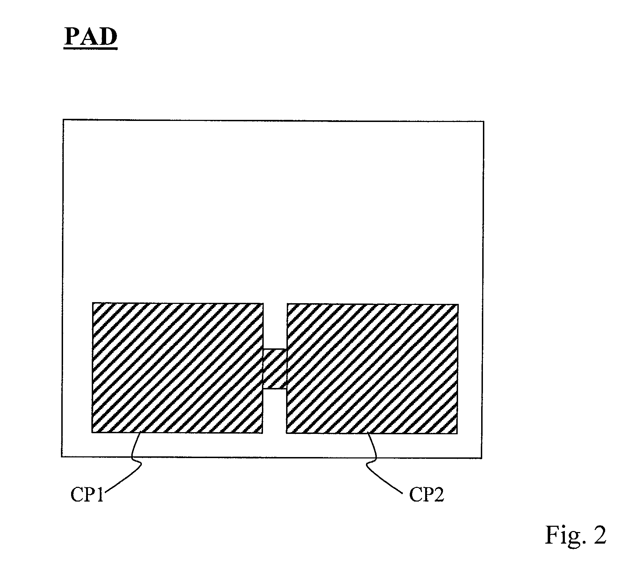

The connection pads are mainly constituted by conductive rectangles disposed on the chip. During the test of the Flash-EEPROM in the foundry, the connection path is probed twice. Then, it is probed again for testing the digital part of the functional logic 1 by coupling a digital tester thereto. It is finally probed a third time for testing the analog part of the functional logic 1 by coupling an analog tester thereto. The connection pad will then be made available for bonding. However, it is known that a good bonding can only be achieved on connection pads that have not been probed more than two times. Therefore, the connections pads are duplicated into a pad arrangement, such as PAD shown at Fig. 2. The pad arrangement PAD mainly comprises two juxtaposed connection pads CP1 and CP2 having substantially the same design and electrically interconnected to each other.

A first connection pad, say CP1, is used for the first two probing operations, whilst the second connection pad, say CP2, is used for the next probing operation. The bonding may then be realized on either which connection pad CP1 or CP2 because none of them has been probed more than twice. The connection pad, e.g. CP1, that is not used for bonding may then be covered during the packaging process and thereby be made inaccessible after the test procedure.

It is to be noted that a pad arrangement as PAD may comprise more than two connection pads if, for instance, more than four probings are required.

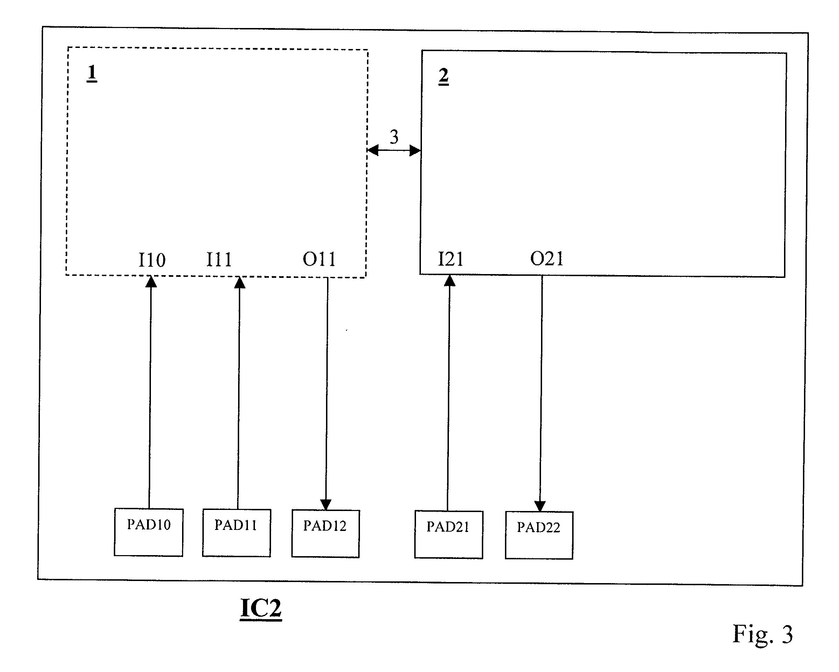

In a preferred embodiment of the present invention, shown at Fig. 3 by referring to an integrated circuit IC2 similar to IC1, dedicated connection pads are used. This means that the input ports I10 and I11 of the functional logic 1 are directly connected to connection pads PAD10 and PAD11 respectively, whilst the output port O11 is connected to a connection pad PAD12. Furthermore, the input port I21 and the output port 021 of the Flash-EEPROM 2 are respectively connected to connection pads PAD 21 and PAD22. In this embodiment, the pad cell count is increased, but this should not have an impact on the chip area. Indeed, because of the chip area required by the Flash-EEPROM and the absence of external interface for external memory, the chip is generally not pad limited. Even if this could have an impact, some mixing devices can still be added to reduce the additional pad cells number, and some pad arrangements as mentioned above may be used. However, as dedicated pads are only used for the test, the above mentioned mixing with functional signals is generally no longer required. This simplifies the design.

The connection pads that are only used for test purpose, i.e. for probing, will not be bounded during packaging operation and will then not be available at package level.

A final remark is that embodiments of the present invention are described above in terms of functional blocks. From the functional description of these blocks, given above, it will be apparent for a person skilled in the art of designing electronic devices how embodiments of these blocks can be manufactured with well-known electronic components. A detailed architecture of the contents of the functional blocks hence is not given.

While the principles of the invention have been described above in connection with specific apparatus, it is to be clearly understood that this description is made only by way of example and not as a limitation on the scope of the invention, as defined in the appended claims.

## Claims

1. An integrated circuit (IC1) comprising functional logic (1) and Flash-EEPROM (2) coupled to at least one connection pad of said integrated circuit,
**characterized in that** several connection pads (CP1, CP2) are arranged into a pad arrangement (PAD: PAD1, PAD2, PAD3, PAD4),
**and in that** said integrated circuit (IC1) further comprises mixing devices (IMUX, OMUX) adapted to couple said functional logic (1) and said Flash-EEPROM (2) to a connection pad of said pad arrangement (PAD).

2. The integrated circuit according to claim 1,
**characterized in that** said pad arrangement (PAD) comprises at least two juxtaposed connection pads (CP1, CP2) interconnected electrically.

3. The integrated circuit according to claim 2,
**characterized in that** said two juxtaposed connection pads (CP1, CP2) have substantially the same design.

4. The integrated circuit according to claim 1,
**characterized in that** said pad arrangement (PAD) comprises a first connection pad (CP1) adapted to be used for probing and for bonding, and a second connection pad (CP2) adapted to be used only for probing.

5. An integrated circuit (IC2) comprising functional logic (1) and Flash-EEPROM (2) coupled to at least one connection pad of said integrated circuit,
**characterized in that** said integrated circuit (IC2) further comprises a first set of dedicated connection pads (PAD 10, PAD11, PAD 12) coupled to said functional logic (1), and a second set of dedicated connection pads (PAD21, PAD22) coupled to said Flash-EEPROM (2).

6. The integrated circuit according to any of the claims 1 or 5,
**characterized in that** said functional logic (1) comprises analog logic and digital logic.
